# EUROPEAN PATENT APPLICATION

(11) **EP 4 773 154 A1**
(43) Date of publication of application: **08.07.2026**
(21) Application number: 24945341.6
(22) Date of filing: 26.11.2024
(51) Int. Cl.: H01B 12/02, H01B 12/10

(54) **MGB2 SUPERCONDUCTING WIRE AND PREPARATION METHOD THEREFOR**

(30) Priority: 17.06.2024 CN 202410773283
(71) Applicant: Xi'an Superconducting Wire Technologies Co., Ltd., Xi'an, Shaanxi 713703 (CN)
(72) Inventor: GUO, Qiang, Xi'an, Shaanxi 713703 (CN); WANG, Mingjiang, Xi'an, Shaanxi 713703 (CN); ZHU, Yanmin, Xi'an, Shaanxi 713703 (CN); YAN, Lingxiao, Xi'an, Shaanxi 713703 (CN); WU, Bo, Xi'an, Shaanxi 713703 (CN); SHI, Yigong, Xi'an, Shaanxi 713703 (CN); LI, Jianfeng, Xi'an, Shaanxi 713703 (CN); LIU, Xianghong, Xi'an, Shaanxi 713703 (CN); DU, Yuxuan, Xi'an, Shaanxi 713703 (CN); FENG, Yong, Xi'an, Shaanxi 713703 (CN); ZHANG, Pingxiang, Xi'an, Shaanxi 713703 (CN)
(74) Representative: Lin Chien, Mon-Yin
(86) International application number: PCT/CN2024/134505
(87) International publication number: WO 2025/260613

(57) **Abstract**

The disclosure belongs to superconducting materials technology field and discloses a MgB₂ superconducting wire and a preparation method, including: obtaining a Mg alloy ingot by melting Mg, Cu, and Ti, and processing it to obtain a Mg alloy rod, packing the Mg alloy rod and B powder into a Nb tube to obtain a composite rod, processing the composite rod to obtain a single-core wire, packing the single-core wire into an oxygen-free copper tube then into a Monel alloy tube; performing cold molding to obtain a multi-core composite wire; then performing high-temperature phase transformation heat treatment on it to obtain the MgB₂ superconducting wire. This application uses a Mg alloy rod containing Cu and Ti as Mg source for preparing MgB₂ multi-core wires, improving plastic deformation ability of the Mg alloy rod during processing, enhancing the grain boundary coupling degree, thereby improving current-carrying performance of the MgB₂ superconducting wire.

## Description

### TECHNICAL FIELD

The present disclosure belongs to the technical field of superconducting materials and discloses a MgB₂ superconducting wire and preparation method therefor.

### BACKGROUND

Since the critical transition temperature reaches 39K, MgB₂ (magnesium diboride) superconducting material is allowed to be operated in the liquid hydrogen or cryogenic refrigeration temperature range (15~25K) without the need for expensive liquid helium. Magnesium and boron are abundant in nature and have low industrial production costs, giving practical MgB₂ superconducting materials a significant competitive advantage in engineering applications. Currently, the preparation of practical MgB₂ superconducting wires/bands uses powder-in-tube technology, mainly including In-situ, E-situ, and Internal Magnesium diffusion (IMD) methods. Research shows that the grain connectivity and filling density of the MgB₂ phase are key factors affecting the superconducting transmission performance of the wire. The density of the MgB₂ phase prepared by the IMD method is significantly higher than that of the in-situ and ex-situ methods. Moreover, the IMD method can achieve strong grain boundary coupling in the MgB₂ phase, resulting in a significantly higher critical current density (Jc) of MgB₂ wires prepared by the IMD method compared to the in-situ or ex-situ methods.

The IMD method typically involves placing a Mg rod in a Nb or Ta tube, filling the gap between the Mg rod and the inner wall of the tube with B powder, processing it into a single-core rod, further assembling the single-core rods and inserting them into a Cu-Ni alloy tube, and finally forming multi-core MgB₂ wires through cold working. However, due to the close-packed hexagonal lattice structure of Mg metal, which has a low slip coefficient and poor plastic deformation ability, the internal Mg rods are prone to fracture when preparing multi-core MgB₂ wires by the IMD method, ultimately reducing the stability of long wire processing and degrading the current-carrying performance of the wires.

### SUMMARY

To overcome the existing technical problems, the present disclosure provides a MgB2 superconducting wire and preparation method therefor. Compared with the existing technology, the advantages of the present disclosure lie in using a Mg alloy rod that has been melted and doped with Cu and Ti elements as the central Mg diffusion source, and further covering the Mg alloy rod with an oxygen-free Cu tube. This method not only helps to improve the plastic deformation ability of the Mg alloy rod during the cold working of the MgB₂ wire, but also enables the wire to obtain good thermal stability and higher current-carrying performance under an external field.

On one hand, the present disclosure relates to a preparation method for MgB₂ superconducting wire, which includes: obtaining a Mg alloy ingot through melting Mg, Cu, and Ti, processing the Mg alloy ingot to obtain a Mg alloy rod, and packing the Mg alloy rod and B powder into a Nb tube to obtain a composite rod;

processing the composite rod to obtain a single-core wire, packing the single-core wire into an oxygen-free copper tube, densely packing the oxygen-free copper tubes into a Monel alloy tube, and obtaining a multi-core composite wire through cold molding;

performing high-temperature phase transformation heat treatment on the multi-core composite wire to obtain the MgB₂ superconducting wire.

Further, in the preparation method of the MgB₂ superconducting wire provided by the present disclosure, the Mg alloy ingot contains Mg, Cu, and Ti in a mass ratio of 0.8~0.9:0.05:0.05~0.15.

Further, in the preparation method of the MgB₂ superconducting wire provided by the present disclosure, the method of melting is electron beam melting.

Further, in the preparation method of the MgB₂ superconducting wire provided by the present disclosure, during the preparation of the single-core wire, the purity of the Nb tube is equal to or more than 99.99%, and the proportion of Nb in the MgB₂ superconducting wire is 10%~12%; the diameter of the single-core wire is 3.8mm to 7.8mm.

Further, in the preparation method of the MgB₂ superconducting wire provided by the present disclosure, the outer diameter of the oxygen-free Cu tube is 12mm, the wall thickness is 2mm to 4mm, and the purity is equal to or more than 99.9%; the core number of the single-core wire is 37 to 136.

Further, in the preparation method of the MgB₂ superconducting wire provided by the present disclosure, the high-temperature phase transformation heat treatment temperature is 500°C to 900°C, and the holding time is 5h to 15h.

On the other hand, the present disclosure relates to a MgB₂ superconducting wire, which is obtained by the above preparation method for MgB₂ superconducting wire.

Compared with the existing technology, the technical solution provided by the present disclosure has the following beneficial effects or advantages:
(1) The present disclosure uses a Mg alloy rod containing Cu and Ti metal elements as the Mg source for preparing MgB₂ multi-core wire. On one hand, the doping of Cu and Ti elements will enhance the plastic deformation ability of the Mg alloy rod during the wire processing. On the other hand, the Cu element provides a channel for the diffusion reaction of Mg element to B element, increasing the activity of the MgB₂ phase transformation reaction, and the Ti element will further refine the MgB₂ grains and improve the grain boundary coupling degree.
(2) In the present disclosure, the single-core wire (with a base of Nb) processed once is packed into an oxygen-free Cu tube, and then is assembled and processed again. Through this method, a Cu-based substrate is provided for the MgB₂ wire to improve the thermal stability of the wire.
(3) The MgB₂ superconducting wire prepared by the preparation method of the present disclosure has MgB₂ grain sizes of 50 to 80nm, with good connectivity between grains.

### ILLUSTRATED DESCRIPTION

To better illustrate the technical solutions in the embodiments of the present disclosure or the existing technology, the following will briefly introduce the required attached figures in the descriptions of the embodiments or the existing technology. Obviously, the attached figures described below are only some embodiments of the present disclosure. For ordinary technicians in this field, without the need for creative labor, other attached figures can also be obtained based on these figures.
Figure 1 shows the microscopic morphology of the MgB₂ superconducting wire prepared in Embodiment 1 of the present disclosure.
Figure 2 shows the microscopic morphology of the MgB₂ superconducting wire prepared in Embodiment 2 of the present disclosure.
Figure 3 shows the microscopic morphology of the MgB₂ superconducting wire prepared in Embodiment 3 of the present disclosure.
Figure 4 shows the microscopic morphology of the MgB₂ superconducting wire prepared in Comparative Example 1 of the present disclosure.
Figure 5 shows the J_{c}-B curves of the MgB₂ superconducting wires prepared in Embodiment 1, Embodiment 2, Embodiment 3 and Comparative Example 1 of the present disclosure.

### DETAILED DESCRIPTION

Next, the technical solution of the present disclosure will be explained based on the examples. However, the present disclosure is not limited to the following examples.

The experimental methods and detection methods described in each of the following examples, unless otherwise specified, are conventional methods; the reagents and materials, unless otherwise specified, can be purchased from the market.

The present disclosure provides a preparation method for a high critical current density MgB₂ superconducting wire, which is specifically implemented according to the following steps:

### Example 1

This example provides a method for preparing MgB₂ superconducting wire.

Step 1: a Mg alloy ingot is obtained by electron beam melting of Mg, Cu, and Ti, and the mass percentages of Mg, Cu, and Ti is 0.9:0.05:0.05.

Step 2: a Mg alloy rod is obtained by extruding and rolling the Mg alloy. The straightness of the Mg alloy rod is 4mm/1000mm. Further, the surface of the Mg alloy rod is cleaned and polished for later use.

Step 3: in a glove box with pure argon gas of 99.999% flowing through, the Mg alloy rod is insert into a Nb tube with a purity of 99.9% and a straightness of 4mm/1000mm. The gap area between the inner walls of the Mg alloy rod and the Nb tube is filled with nano B powder (with a purity of 99.9% and a particle size of 2µm), to obtain a composite rod. Finally, the composite rod is processed into a single-core wire with a diameter of 7.8mm. The single-core wire is further straightened and cut off.

Step 4: after surface cleaning, the single-core wire is insert into an oxygen-free Cu tube with an outer diameter of 12mm and a wall thickness of 2mm. The oxygen-free Cu tubes are then densely packed into a Monel alloy tube, and finally be cold plasticized to obtain a multi-core composite wire with 37-cores and a diameter of 2mm.

Step 5: in a vacuum environment, the multi-core composite wire is heated to 500°C and kept for 15 hours to obtained a MgB₂ superconducting wire with superconducting properties.

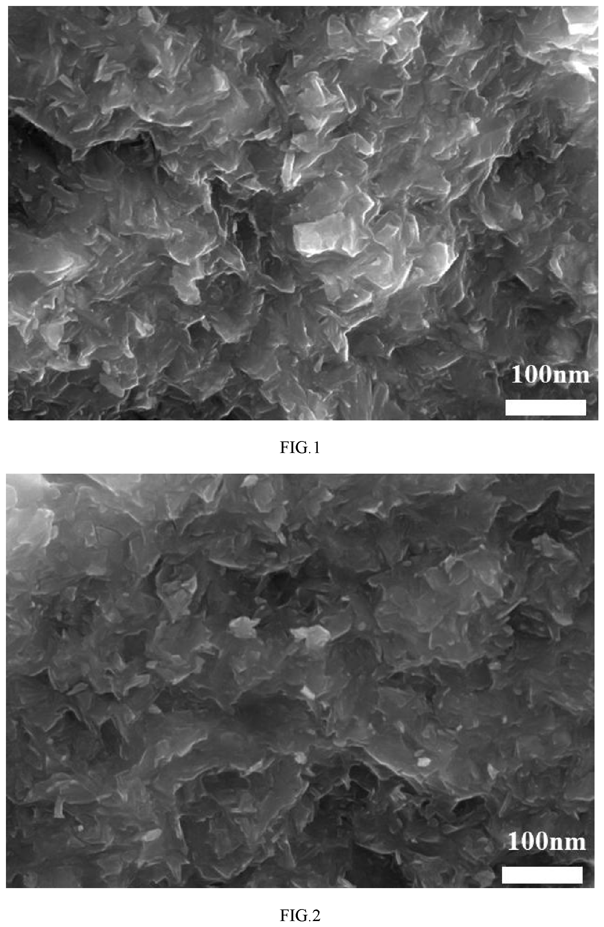

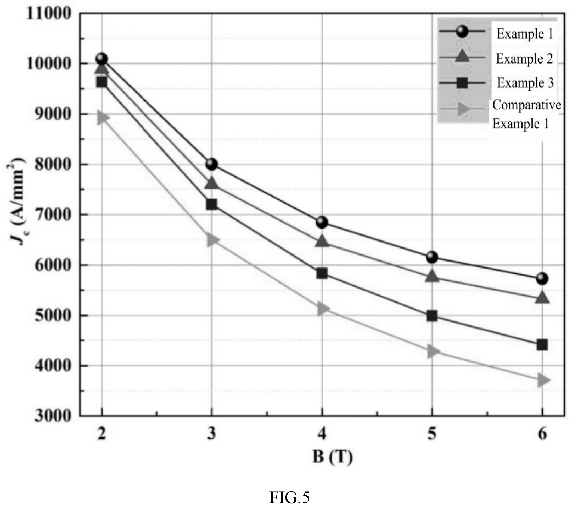

Figure 1 shows the microscopic morphology of the MgB₂ superconducting wire prepared in this example. As can be seen from the figure, the MgB₂ crystal grain size of the MgB₂ superconducting wire prepared in this example is approximately 80nm, with no holes between the grains and a dense connection. Figure 5 shows the critical current density values (J_{c}-B curve) of the prepared MgB₂ superconducting wire under different test conditions (4.2K, 3T). Under the condition of 4.2K and 3T, the critical current density of the MgB₂ superconducting wire prepared in this example reaches 7200A/mm².

### Example 2

This example provides a method for preparing MgB₂ superconducting wire.

Step 1: a Mg alloy ingot is obtained by electron beam melting of Mg, Cu, and Ti, and the mass percentages of Mg, Cu, and Ti is 0.85:0.05:0.1.

Step 2: a Mg alloy rod is obtained by extruding and rolling the Mg alloy ingot. The straightness of the Mg alloy rod being 4mm/1000mm. Further, the surface of the Mg alloy rod is cleaned and polished for later use.

Step 3: in a glove box with pure argon gas of 99.999% flowing through, the Mg alloy rod is insert into a Nb tube with a purity of 99.9% and a straightness of 4mm/1000mm. The gap area between the inner walls of the Mg alloy rod and the Nb tube is filled with nano B powder (with a purity of 99.9% and a particle size of 2µm), to obtain a composite rod. Finally, the composite rod is processed into a single-core wire with a diameter of 5.8mm. The single-core wire is further straightened and cut off.

Step 4: after surface cleaning, the single-core wire is insert into an oxygen-free Cu tube with an outer diameter of 12mm and a wall thickness of 3mm. The oxygen-free Cu tubes are then densely packed into a Monel alloy tube, and finally be cold plasticized to obtain a multi-core composite wire with 88-cores and a diameter of 2mm.

Step 5: in a vacuum environment, the multi-core composite wire is heated to 700°C and held for 10 hours to obtained a MgB₂ superconducting wire with superconducting properties.

Figure 2 shows the microscopic morphology of the MgB₂ superconducting wire prepared in this embodiment. As can be seen from the figure, the MgB₂ grain size of the MgB₂ superconducting wire prepared in this embodiment is approximately 65 nm. Compared with Example 1, with the reduction of grain size, the density between MgB₂ grains also increases. Figure 5 shows the critical current density values (J_{c}-B curve) of the prepared MgB₂ superconducting wire under different testing conditions. Under the condition of 4.2K and 3T, the critical current density of the MgB₂ wire prepared in this embodiment reaches 7600 A/mm².

### Example 3

This example provides a method for preparing MgB₂ superconducting wire.

Step 1: a Mg alloy ingot is obtained by electron beam melting of Mg, Cu, and Ti, and the mass percentages of Mg, Cu, and Ti is 0.90:0.05:0.15.

Step 2: a Mg alloy rod is obtained by extruding and rolling the Mg alloy ingot. The straightness of the Mg alloy rod being 4mm/1000mm. Further, the surface of the Mg alloy rod is cleaned and polished for later use.

Step 3: in a glove box with pure argon gas of 99.999% flowing through, the Mg alloy rod is insert into a Nb tube with a purity of 99.9% and a straightness of 4mm/1000mm. The gap area between the inner walls of the Mg alloy rod and the Nb tube is filled with nano B powder (with a purity of 99.9% and a particle size of 2µm), to obtain a composite rod. Finally, the composite rod is processed into a single-core wire with a diameter of 3.8mm. The single-core wire is further straightened and cut off.

Step 4: after surface cleaning, the single-core wire is insert into an oxygen-free Cu tube with an outer diameter of 12mm and a wall thickness of 4mm. The oxygen-free Cu tubes are then densely packed into a Monel alloy tube, and finally be cold plasticized to obtain a multi-core composite wire with 136-cores and a diameter of 2mm.

Step 5: in a vacuum environment, the multi-core composite wire is heated to 700°C and held for 10 hours to obtained a MgB₂ superconducting wire with superconducting properties.

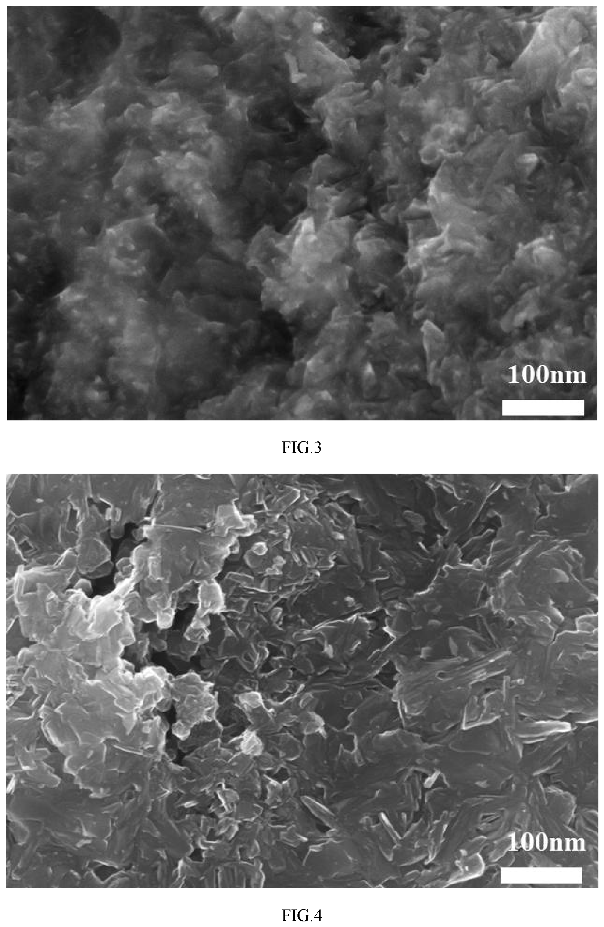

Figure 3 shows the microscopic morphology of the MgB₂ superconducting wire prepared in this embodiment. As can be seen from the figure, the MgB₂ grain size of the MgB₂ superconducting wire prepared in this embodiment is approximately 50 nm. The density of MgB₂ grains has also significantly improved compared to Example 1 and Example 2. Compared with Example 1 and Example 2, the MgB₂ grain size of the wire prepared in this embodiment is further reduced. Figure 5 shows the critical current density values (J_{c}-B curve) of the prepared MgB₂ superconducting wire under different testing conditions. Under the condition of 4.2K and 3T, the critical current density of the MgB₂ wire prepared in this embodiment reaches 8000 A/mm².

### Comparative Example 1

This example provides a method for preparing a MgB₂ superconducting wire.

The difference between the Example 1 and the Comparative Example 1 is that during the wire preparation process, the Mg rod without doping Cu and Ti elements is directly used as the diffusion Mg source, and finally a MgB₂ superconducting wire with 37-cores is obtained.

Figure 4 shows the microscopic morphology of the MgB₂ superconducting wire prepared in this Comparative Example 1. From the figure, it can be seen that the MgB₂ grain size of the MgB₂ superconducting wire prepared in this Comparative Example 1 is approximately 100 nm, and there are amounts of microscopic holes in the crystal structure, which reduces the compactness and connectivity between the grains. Figure 5 shows the critical current density values (J_{c}-B curve) of the prepared MgB₂ superconducting wire under different test conditions. Under the condition of 4.2K and 3T, the critical current density of the MgB₂ wire prepared in this Comparative Example 1 reaches 6500 A/mm². Compared with Examples 1, 2, and 3, the MgB₂ grain size of the wire prepared in this Comparative Example 1 is larger, and the corresponding critical current density of the wire is lower. Thus, it can be seen that in this disclosure, by doping a small amount of Cu and Ti elements in the Mg rod through the melting method, the reaction activity in the MgB₂ phase formation process is increased, the MgB₂ grains are refined, and the grain boundary connectivity is improved, thereby enabling the wire to obtain a higher current-carrying performance.

As mentioned above, this provides a good description of the basic principle, main features, and advantages of the disclosure. The above examples and the description in the specification merely describe the preferred implementation methods of the disclosure. The disclosure is not limited by the above examples. Under the premise of not departing from the spirit and scope of the disclosure, ordinary technical personnel in the field can make various changes and improvements to the technical solutions of the disclosure, and such changes and improvements shall fall within the protection scope determined by the disclosure.

## Claims

1. A method for preparing a MgB₂ superconducting wire, comprising: obtaining a Mg alloy ingot through melting Mg, Cu, and Ti; processing the Mg alloy ingot to obtain a Mg alloy rod; packing the Mg alloy rod and B powder into a Nb tube to obtain a composite rod;
processing the composite rod to obtain a single-core wire; packing the single-core wire into an oxygen-free copper tube; densely packing the oxygen-free copper tubes into a Monel alloy tube, and obtaining a multi-core composite wire by cold molding;
performing high-temperature phase transformation heat treatment on the multi-core composite wire to obtain the MgB₂ superconducting wire.

2. The method of claim 1, wherein the mass percentage of Mg, Cu, and Ti in the Mg alloy ingot is 0.8~0.9:0.05:0.05~0.15.

3. The method of claim 1, wherein the method of melting is electron beam melting.

4. The method of claim 1, wherein the purity of the Nb tube is equal to or more than 99.99%, and the diameter of the single-core wire is 3.8mm to 7.8mm.

5. The method of claim 1, wherein the outer diameter of the oxygen-free copper tube is 12mm, the wall thickness is 2mm to 4mm, and the purity is equal to or more than 99.9%; the number of cores of the composite wire is 37 to 136.

6. The method of claim 1, wherein the temperature of the high-temperature phase transformation heat treatment is 500°C to 900°C, and the holding time is 5h to 15h.

7. A MgB₂ superconducting wire, obtained by the method of any one of claims 1 to 6.

8. The superconducting wire of claim 7, wherein the grain size of MgB₂ in the superconducting wire is 50 to 80nm.
